# EUROPEAN PATENT APPLICATION

(11) **EP 4 782 266 A1**
(43) Date of publication of application: **29.07.2026**
(21) Application number: 25226816.4
(22) Date of filing: 23.12.2025
(51) Int. Cl.: B60L 58/27, B60L 53/64, B60L 53/66, B60L 58/12, B60L 1/12

(54) **ELECTRIFIED VEHICLE AND TEMPERATURE CONTROL METHOD OF STORAGE BATTERY**

(30) Priority: 24.01.2025 JP 2025010712
(71) Applicant: Toyota Jidosha Kabushiki Kaisha, Toyota-shi, Aichi-ken 471-8571 (JP)
(72) Inventor: HONDA, Iichiro, Toyota-shi, 471-8571 (JP)
(74) Representative: J A Kemp LLP

(57) **Abstract**

The temperature of a battery is raised by an electric heater. A planning unit of an ECU creates a temperature raising plan. A charge electric power amount fee unit price calculation unit calculates a charge electric power amount fee unit price. The temperature raising plan is created such that electric power of the battery is supplied to the electric heater in a time slot in which an electric power amount fee unit price of the external power supply is higher than the charge electric power amount fee unit price, and electric power of the external power supply is supplied to the electric heater in a time slot in which the electric power amount fee unit price is equal to or lower than the charge electric power amount fee unit price. A power controller supplies electric power to the electric heater based on the temperature raising plan.

## Description

### BACKGROUND OF THE INVENTION

### 1. Field of the Invention

The present disclosure relates to an electrified vehicle and a temperature control method of a storage battery, and particularly to an electrified vehicle including a storage battery that can be charged from an external power supply.

### 2. Description of Related Art

Japanese Unexamined Patent Application Publication No. 2016-201321 (JP 2016-201321 A) discloses a temperature raising device of a battery mounted on an electrified vehicle. The electrified vehicle can be connected to an external power supply. The temperature raising device controls an electric heater such that the temperature of a battery is equal to or higher than a first lower limit temperature until a first predetermined period elapses from the start of external charging of the battery, and controls the electric heater such that the temperature of the battery is equal to or higher than a second lower limit temperature after the first predetermined period elapses. The second lower limit temperature is a temperature lower than the first lower limit temperature.

### SUMMARY OF THE INVENTION

In a temperature raising device that uses electric power, such as an electric heater, an electricity fee is incurred based on the electric power amount used from the external power supply. JP 2016-201321 A does not mention the electricity fee.

An object of the present disclosure is to suppress an electricity fee required for raising the temperature of a storage battery mounted on an electrified vehicle.

An electrified vehicle according to the present disclosure is an electrified vehicle that includes a storage battery configured to be charged by electric power to be supplied from an external power supply, the electrified vehicle including a temperature raising device configured to raise a temperature of the storage battery by using electric power, and a control device configured to control the temperature raising device. The control device includes a planning unit configured to create a temperature raising plan from an end of charging to a scheduled traveling start time of the electrified vehicle such that the temperature of the storage battery is a predetermined temperature at the scheduled traveling start time, and a power controller configured to control the electric power to be supplied to the temperature raising device based on the temperature raising plan. The planning unit is configured to calculate a charge electric power amount fee unit price that is a unit price of an electricity fee required for current charging, and create the temperature raising plan such that electric power of the storage battery is used in a time slot in which an electric power amount fee unit price of the external power supply is higher than the charge electric power amount fee unit price, and the electric power of the external power supply is used in a time slot in which the electric power amount fee unit price is equal to or lower than the charge electric power amount fee unit price.

According to this configuration, the planning unit of the control device creates the temperature raising plan from the end of the charging to the scheduled traveling start time of the electrified vehicle such that the temperature of the storage battery is the predetermined temperature at the scheduled traveling start time. The power controller controls the electric power to be supplied to the temperature raising device based on the temperature raising plan. Since the temperature of the storage battery reaches the predetermined temperature at the start of traveling, the electrified vehicle can exhibit favorable performance.

The temperature raising plan is created such that the charge electric power amount fee unit price that is the unit price of the electricity fee required for the current charging is calculated, the electric power of the storage battery is used in a time slot in which the electric power amount fee unit price of the external power supply is higher than the charge electric power amount fee unit price, and the electric power of the external power supply is used in a time slot in which the electric power amount fee unit price is equal to or lower than the charge electric power amount fee unit price. Accordingly, the power controller supplies the electric power of the storage battery to the temperature raising device in the time slot in which the electric power amount fee unit price of the external power supply is higher than the charge electric power amount fee unit price, and raises the temperature of the storage battery, so that the electricity fee required for raising the temperature can be suppressed.

Preferably, the power controller may supply the electric power of the external power supply to the temperature raising device in a case where a state of charge (SOC) of the storage battery is equal to or less than a predetermined value.

According to this configuration, since the SOC of the storage battery is not equal to or less than the predetermined value at the start of traveling of the electrified vehicle, a decrease in the electric power amount used during traveling can be suppressed.

A temperature control method of a storage battery according to the present disclosure is a temperature control method of a storage battery of which a temperature is raised by a temperature raising device, the storage battery being mounted on a vehicle and configured to be charged from an external power supply. The temperature raising device is configured to raise the temperature of the storage battery by using electric power. The temperature control method includes acquiring a scheduled traveling start time of an electrified vehicle, acquiring a target temperature of the storage battery at the scheduled traveling start time, acquiring a charge electricity fee for charge electric power amount from a start of charging to an end of charging from the external power supply, acquiring an electric power amount fee unit price of the external power supply, calculating a charge electric power amount fee unit price based on the charge electricity fee, creating a temperature raising plan from the end of the charging to the scheduled traveling start time such that the temperature of the storage battery is the target temperature at the scheduled traveling start time, and controlling the temperature raising device based on the temperature raising plan. The temperature raising plan is created such that electric power of the storage battery is supplied to the temperature raising device in a time slot in which the electric power amount fee unit price of the external power supply is higher than the charge electric power amount fee unit price, and electric power of the external power supply is supplied to the temperature raising device in a time slot in which the electric power amount fee unit price is equal to or lower than the charge electric power amount fee unit price.

According to this method, the temperature raising plan from the end of the charging to the scheduled traveling start time is created such that the temperature of the storage battery is the target temperature at the scheduled traveling start time of the electrified vehicle. The method acquires the charge electricity fee for the charge electric power amount from the start of charging to the end of charging from the external power supply, and calculates the charge electric power amount fee unit price based on the charge electricity fee. In a case where the electric power is supplied to the temperature raising device based on the temperature raising plan, the method uses the electric power of the storage battery in the time slot in which the electric power amount fee unit price of the external power supply is higher than the charge electric power amount fee unit price, and uses the electric power of the external power supply in the time slot in which the electric power amount fee unit price is equal to or lower than the charge electric power amount fee unit price.

In the method, the electric power of the storage battery is supplied to the temperature raising device in the time slot in which the electric power amount fee unit price of the external power supply is higher than the charge electric power amount fee unit price, and the temperature of the storage battery is raised, so that the electricity fee required for raising the temperature can be suppressed.

Preferably, the temperature control method further includes acquiring an SOC of the storage battery, in which the electric power of the external power supply may be supplied to the temperature raising device even in a time slot in which the electric power of the storage battery is supplied to the temperature raising device in a case where the SOC is equal to or less than a predetermined value.

According to this method, since the SOC of the storage battery is not equal to or less than the predetermined value at the start of traveling of the electrified vehicle, a decrease in the electric power amount used during traveling can be suppressed.

According to the present disclosure, the electricity fee required for raising the temperature of the storage battery mounted on the electrified vehicle can be suppressed.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is an overall configuration diagram of an electrified vehicle according to a present embodiment;
FIG. 2 is a flowchart showing an example of temperature raising control during plug-in executed by an ECU in the present embodiment; and
FIG. 3 is a diagram showing an example of a functional block implemented in the ECU.

### DETAILED DESCRIPTION OF EMBODIMENTS

In the following, an embodiment of the present disclosure will be described in detail with reference to the drawings. It should be noted that, in the drawings, the same or corresponding parts are designated by the same reference signs and the description thereof will not be repeated.

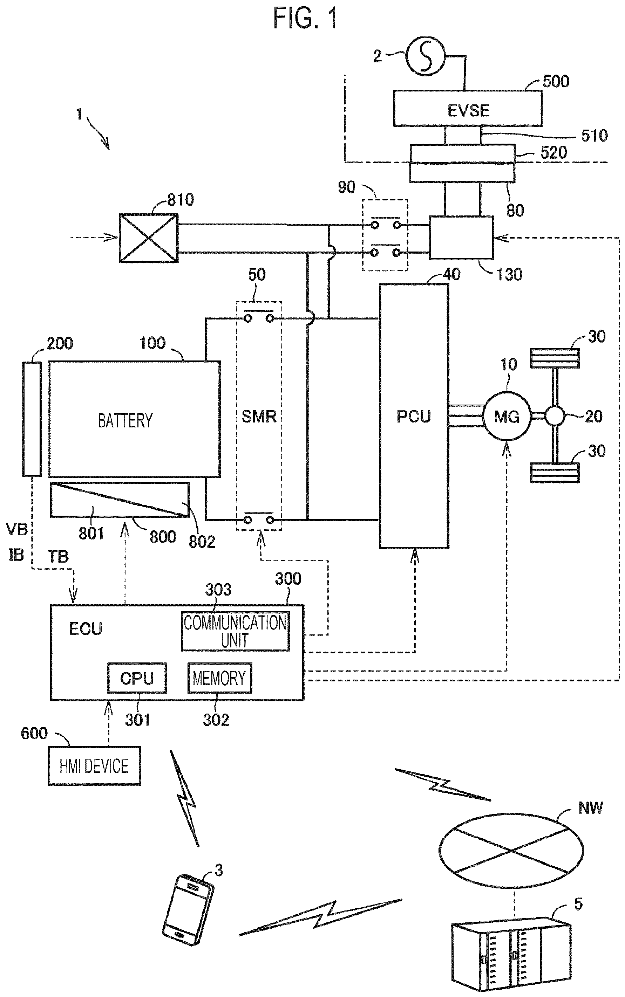

FIG. 1 is an overall configuration diagram of an electrified vehicle 1 according to a present embodiment. In the present embodiment, the electrified vehicle 1 is, for example, a battery electric vehicle (BEV). The electrified vehicle 1 includes a motor generator (MG) 10 that is a rotating electric machine, a power transmission gear 20, drive wheels 30, a power control unit (PCU) 40, a system main relay (SMR) 50, a battery 100, a monitoring unit 200, and an electronic control unit (ECU) 300 that is an example of a control device.

The MG 10 is, for example, an interior permanent magnet (IPM) motor, and has a function as a motor and a function as a generator. The output torque of the MG 10 is transmitted to the drive wheels 30 via the power transmission gear 20 configured to include a speed reducer, a differential device, and the like.

In a case of braking the electrified vehicle 1, the MG 10 is driven by the drive wheels 30, and the MG 10 operates as the generator. As a result, the MG 10 also functions as a braking device that performs regenerative braking of converting the kinetic energy of the electrified vehicle 1 into electric power. The regenerative power generated by the regenerative braking force in the MG 10 is stored in the battery 100.

The PCU 40 is an electric power conversion device that bidirectionally converts electric power between the MG 10 and the battery 100. The PCU 40 includes, for example, an inverter and a converter that operate based on a control signal from the ECU 300. The PCU 40 may have a configuration in which the converter is omitted.

The SMR 50 is electrically connected to an electric power line connecting the battery 100 and the PCU 40. In a case where the SMR 50 is closed (ON) (conduction state) in response to the control signal from the ECU 300, electric power can be exchanged between the battery 100 and the PCU 40. On the other hand, in a case where the SMR 50 is opened (OFF) (cut-off state) in response to the control signal from the ECU 300, the electric connection between the battery 100 and the PCU 40 is cut off.

The battery 100 stores electric power for driving the MG 10. The battery 100 is a rechargeable direct current power supply (secondary battery), and is configured by laminating a plurality of single cells (battery cells), for example, electrically connected in series. The battery 100 corresponds to a storage battery. The single cell is configured with, for example, a lithium ion battery. The single cell may be a nickel hydrogen battery or an all-solid state battery. The battery 100 corresponds to a "storage battery" of the present disclosure.

The monitoring unit 200 includes a voltage detection unit, a current sensor, and a temperature detection unit. The voltage detection unit detects a voltage VB of the battery. The current sensor detects a current IB input and output to and from the battery 100. The temperature detection unit detects a temperature TB of the battery 100. Each detection unit outputs a detection result to the ECU 300.

The electrified vehicle 1 includes an alternating current (AC) inlet 80, and the battery 100 can be charged (externally charged) from electric vehicle supply equipment (EVSE) 500 that supplies electric power of an external AC power supply 2 to the electrified vehicle 1. The AC inlet 80 is configured to be connectable to a connector 520 provided at a distal end of a charging cable 510 of the EVSE 500. A vehicle-mounted charger 130 is provided in an electric power line between the AC inlet 80 and the battery 100, and converts alternating current power supplied from the external AC power supply into direct current power and converts the direct current power into a voltage capable of charging the battery 100. The charging relay 90 is electrically connected to an electric power line connecting the vehicle-mounted charger 130 and the battery 100. The charging relay 90 switches between supplying and cutting off the electric power between the vehicle-mounted charger 130 and the battery 100 in response to the control signal from the ECU 300. In a case where the charging relay 90 is closed and the SMR 50 is closed, the external charging (normal charging) of the battery 100 is executed. The EVSE 500 may be a type including a control circuit therein. In addition, the EVSE 500 may be a socket that outputs the external AC power supply 2, and the charging cable 510 may include a control circuit. The external charging may be performed by using EVSE that outputs direct current power to charge the battery 100.

The external AC power supply 2 corresponds to an "external power supply" of the present disclosure. In the present embodiment, the external AC power supply 2 is a commercial power supply, and an electric power amount fee unit price [Yen/kWh] varies depending on the time slot, the weekday or the weekend, the season, and the like.

The ECU 300 includes a central processing unit (CPU) 301, a memory (including, for example, a read only memory (ROM), a random access memory (RAM), or the like) 302, and a communication unit 303. The ECU 300 controls each device such that the electrified vehicle 1 is in a desired state based on a signal received from the monitoring unit 200, a signal (for example, an accelerator operation amount signal and a vehicle speed signal) from various sensors (not shown), and information such as a map and a program stored in the memory 302. The ECU 300 calculates a state of charge (SOC) of the battery 100 based on the voltage VB, the current IB, and the like. In addition, the ECU 300 controls a temperature adjustment device 800 described below. The communication unit 303 includes a communication interface (I/F) for performing wireless communication with a network NW and a user terminal 3. The communication unit 303 may include a telematics control unit (TCU) and/or a data communication module (DCM) that performs wireless communication.

A human machine interface (HMI) device 600 includes an input device and a display device. The HMI device 600 includes a touch panel display that functions as the input device and the display device.

The user terminal 3 is configured to be carried by the user. The user terminal is a mobile terminal that is carried and operated by the user (vehicle administrator) of the electrified vehicle 1. In the present embodiment, a smartphone including a touch panel display is adopted as the user terminal 3. As the user terminal 3, any terminal that can be carried by the user of the electrified vehicle 1 can be adopted. For example, a laptop, a tablet terminal, a portable game machine, a wearable device (a smart watch, smart glasses, a smart glove, or the like), or the like can also be adopted as the user terminal 3. The user terminal 3 can communicate with the communication unit 303 by, for example, short-range wireless communication, and can communicate with an external server 5 via the network NW.

The external server 5 is configured to communicate with the electrified vehicle 1 (the communication unit 303) and the user terminal 3 via the network NW. The external server 5 provides weather information around the electrified vehicle 1, electricity fee information of the external AC power supply (commercial power supply), and the like through the network NW.

The electrified vehicle 1 includes a temperature adjustment device 800. The temperature adjustment device 800 adjusts the temperature of the battery 100, and corresponds to an example of a "temperature raising device" of the present disclosure. The temperature adjustment device 800 includes a battery cooling unit (battery cooling system) 801 and a battery temperature raising unit (battery temperature raising system) 802. The temperature adjustment device 800 includes, for example, a battery thermal circuit in which a heat medium that exchanges heat with the battery 100 circulates. The battery cooling unit 801 may adopt a configuration of cooling the heat medium that circulates in the battery thermal circuit using a chiller cooled by, for example, a refrigeration cycle device used in common with indoor air conditioning, to cool the battery 100. The battery temperature raising unit 802 may be configured to heat the heat medium that circulates in the battery thermal circuit by an electric heater 810 to raise the temperature of the battery 100. The battery temperature raising unit 802 may directly heat the battery 100 by the electric heater 810.

The electric heater 810 is supplied with the electric power supplied from the external AC power supply 2 (EVSE 500) and the electric power stored in the battery 100. When the charging relay 90 is closed and the SMR 50 is opened, and the electric heater 810 is operated in a state in which the connector 520 is connected to the AC inlet 80 (hereinafter, this state is also referred to as a "plug-in state"), the electric power of the external AC power supply 2 is energized to the electric heater 810, and the temperature of the battery 100 is raised. When the charging relay 90 is opened and the SMR 50 is closed, and the electric heater 810 is operated in the plug-in state, the electric power of the battery 100 is energized to the electric heater 810, and the temperature of the battery 100 is raised.

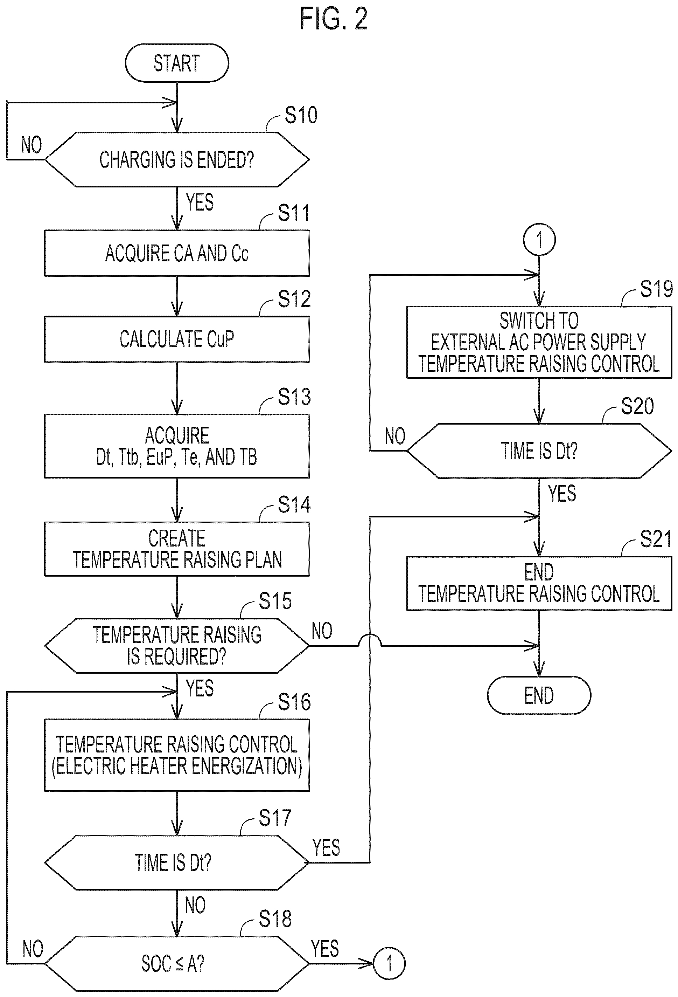

FIG. 2 is a flowchart showing an example of temperature raising control during plug-in executed by the ECU 300 in the present embodiment. The processing shown in the flowchart starts in a case where the connector 520 is connected to the AC inlet 80.

In step 10 (hereinafter, steps are abbreviated as "S"), the ECU 300 determines whether the charging (external charging) of the battery 100 is ended. For example, the charging of the battery 100 is ended in a case where the battery 100 is fully charged or in a case where the SOC of the battery 100 reaches a value (for example, 90%) set by the user. In a case where the charging of the battery 100 is not ended, the processing of S10 is repeated until the charging of the battery 100 is ended. In a case where the charging of the battery 100 is ended, the determination in S10 is affirmative, and the processing proceeds to S11. During the charging of the battery 100, the SMR 50 and the charging relay 90 are closed, and the electric power of the external AC power supply 2 is supplied to the battery 100. In a case where the charging of the battery 100 is ended, the SMR 50 and the charging relay 90 are opened, and the electric power supply to the battery 100 is cut off.

In S11, the ECU 300 acquires a charge electric power amount CA [kWh] and a charge electricity fee Cc [Yen/kWh]. The charge electric power amount CA is the electric power amount used for the current charging, and may be calculated and acquired from, for example, the SOC at the start of charging and the SOC at the end of charging. Alternatively, the charge electric power amount CA may be calculated and acquired by accumulating the current IB (corresponding to a charging current) from the start of charging to the end of charging.

The charge electricity fee Cc is an electricity fee required for the current charging. The charge electricity fee Cc is calculated using the electric power amount fee unit price EuP [Yen/kWh] of the external power supply in each time slot from the start of charging to the end of charging and the electric power amount [kWh] supplied to the battery 100 in each time slot. The electric power amount fee unit price EuP may be acquired from the external server 5. For example, in a case where the charging is ended by using a [kWh] of electric power amount in a time slot in which the electric power amount fee unit price EuP is A [Yen/kWh], using b [kWh] of electric power amount in a time slot in which the electric power amount fee unit price EuP is B [Yen/kWh], and using c [kWh] of electric power amount in a time slot in which the electric power amount fee unit price EuP is C [Yen/kWh], the charge electric power amount CA is CA = a + b + c. The charge electricity fee Cc is calculated and acquired as "Cc = (A × a) + (B × b) + (C × c)".

In subsequent S12, a charge electric power amount fee unit price CuP [Yen/kWh] is calculated. The charge electric power amount fee unit price CuP is an electricity fee unit price required for the current charging, and is a value obtained by dividing the charge electricity fee Cc by the charge electric power amount CA, and is calculated as "CuP = Cc/CA = ((A × a) + (B × b) + (C × c))/(a + b + c)" in the above example.

In S13, the ECU 300 acquires a scheduled traveling start time Dt, a target temperature Ttb, the electric power amount fee unit price EuP, outside air temperature information Te, and the temperature TB. The scheduled traveling start time Dt is a time at which the user starts traveling of the electrified vehicle 1, and is set, for example, by the user inputting to the HMI device 600. In addition, the user may operate the user terminal 3 to set the scheduled traveling start time Dt. Alternatively, the ECU 300 may estimate the scheduled traveling start time Dt from past performance based on the season, the day of the week, and the like. In this case, the scheduled traveling start time Dt may be estimated using a machine-learned learning model.

The target temperature Ttb is a target temperature of the battery 100 at the scheduled traveling start time Dt, and corresponds to an example of a "predetermined temperature" of the present disclosure. The target temperature Ttb is set based on the characteristics of the battery 100, and is set in advance as a temperature at which the function (charge and discharge) of the battery 100 can be favorably exhibited. In the present embodiment, the target temperature Ttb is set to 25°C. The target temperature Ttb may be corrected based on a state of health (SOH) of the battery 100.

The electric power amount fee unit price EuP is the electric power amount fee unit price EuP [Yen/kWh] from the current point in time (at the end of charging) to the scheduled traveling start time Dt. In general, the electric power amount fee unit price EuP is set based on the time slot, the weekday or the weekend, the season, and the like, and is, for example, low in a late-night time slot. The electric power amount fee unit price EuP is acquired from the external server 5.

The outside air temperature information Te is information indicating a change in the outside air temperature around the electrified vehicle 1 from the current point in time to the scheduled traveling start time Dt. The outside air temperature information Te is included in the weather information received from the external server 5. In addition, the temperature TB is the current temperature of the battery 100. In a case of charging the battery 100, the temperature TB of the battery 100 is controlled to a temperature suitable for charging by the temperature adjustment device 800. Therefore, the temperature TB acquired in S13 does not deviate significantly from the target temperature Ttb.

In S14, the ECU 300 creates a temperature raising plan. The temperature raising plan is an electric power supply schedule (energization schedule) of the electric heater 810, and is created such that the temperature TB of the battery 100 is the target temperature Ttb at the scheduled traveling start time Dt. For example, the temperature TB at the scheduled traveling start time Dt in a case where the temperature of the battery 100 is not raised is estimated based on the current temperature TB and the change amount of the outside air temperature from the current time to the scheduled traveling start time Dt. The estimated temperature TB is set as a projected temperature TBn. In a case where the projected temperature TBn is lower than the target temperature Ttb, the electric heater 810 is energized, the temperature of the battery 100 is raised by the temperature adjustment device 800, and an energization schedule is created such that the temperature TB of the battery 100 is the target temperature Ttb at the scheduled traveling start time Dt. In a case where the projected temperature TBn is higher than the target temperature Ttb, the processing proceeds to S15 without creating the temperature raising plan (energization schedule).

The temperature raising plan is an energization schedule including the electric power to be supplied to the electric heater 810, the energization time slot (energization start time and energization end time), and the power source to the electric heater 810. For example, the amount of heat dissipation of the battery 100 is estimated based on the current temperature TB and the change in the outside air temperature from the current time to the scheduled traveling start time Dt, and the energization start time and the energization end time (energization time slot) and the electric power to be supplied are calculated from the amount of heating required for the temperature TB to be the target temperature Ttb at the scheduled traveling start time Dt. The energization time slot and the electric power to be supplied may be calculated such that the electric power amount to be supplied to the electric heater 810 is minimized.

In a case where the electric power to be supplied and the energization time slot in the temperature raising plan are determined, the ECU 300 selects the power source of the electric heater 810. In the energization time slot in which the electric power amount fee unit price EuP is higher than the charge electric power amount fee unit price CuP, the ECU 300 selects the battery 100 as the power source of the electric heater 810. In the energization time slot in which the electric power amount fee unit price EuP is equal to or less than the charge electric power amount fee unit price CuP, the ECU 300 selects the external AC power supply 2 as the power source of the electric heater 810. As described above, the ECU 300 creates the temperature raising plan including the electric power to be supplied to the electric heater 810, the energization time slot (energization start time and energization end time), and the power source to the electric heater 810.

In subsequent S15, the ECU 300 determines whether raising the temperature of the battery 100 is required. In a case where the temperature raising plan is not created in S14, the determination is negative because raising the temperature of the battery 100 is not required, and the current routine ends. In a case where the temperature raising plan is created in S14, the determination is affirmative, and the processing proceeds to S16.

In S16, the ECU 300 supplies the electric power to the electric heater 810 and executes the temperature raising control in accordance with the temperature raising plan created in S14. In a case where the energization start time of the temperature raising plan is reached, the ECU 300 energizes the electric heater 810. The magnitude of the electric power supplied to the electric heater 810 may be adjusted by, for example, a DC-DC converter (not shown). In the temperature raising plan, in the energization time slot in which the external AC power supply 2 is selected as the power source, the SMR 50 is opened and the charging relay 90 is closed to supply the electric power of the external AC power supply 2 to the electric heater 810. In the temperature raising plan, in the energization time slot in which the battery 100 is selected as the power source, the SMR is opened and the charging relay 90 is opened to supply the electric power of the battery 100 to the electric heater 810.

In S17, the ECU 300 determines whether the current time is the scheduled traveling start time Dt. In a case where the current time is the scheduled traveling start time Dt, the determination in S17 is affirmative, and the processing proceeds to S21. In a case where the current time is before the scheduled traveling start time Dt, the determination is negative, and the processing proceeds to S18.

In S18, the ECU 300 determines whether the SOC of the battery 100 is equal to or less than a predetermined value A. The predetermined value A may be a value set in advance as a value at which the electrified vehicle 1 can travel sufficiently by the electric power of the battery 100. The predetermined value A may be set by the user operating the HMI device 600. In a case where the SOC is larger than the predetermined value A, the determination is negative, the processing returns to S16, and the electric power of the external AC power supply 2 is supplied to the electric heater 810 in accordance with the temperature raising plan. In a case where the SOC is equal to or less than the predetermined value A, the determination is affirmative, and the processing proceeds to S19.

In S19, the ECU 300 switches the power source of the electric heater 810 to the external AC power supply 2 and continues the temperature raising control. The ECU 300 opens the SMR 50 and closes the charging relay 90. As a result, the electric power of the external AC power supply 2 is supplied to the electric heater 810 even in the energization time slot in which the battery 100 is selected as the power source.

In subsequent S20, the ECU 300 determines whether the current time is the scheduled traveling start time Dt. In a case where the current time is the scheduled traveling start time Dt, the determination in S20 is affirmative, and the processing proceeds to S21. In a case where the current time is before the scheduled traveling start time Dt, the determination is negative, the processing returns to S19, and the processing of S19 is repeated.

In S21, the ECU 300 ends the temperature raising control and ends the current routine.

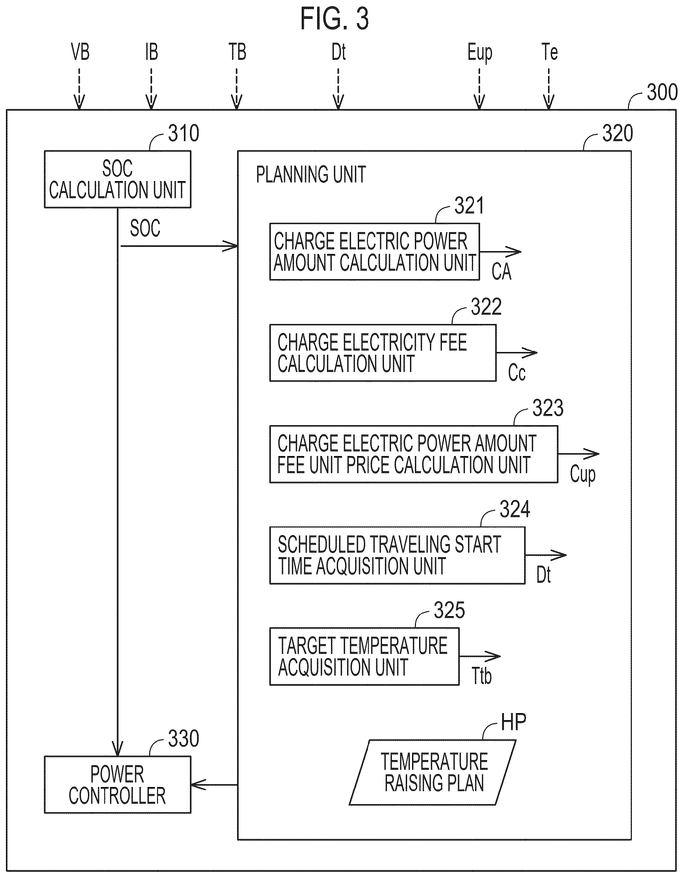

FIG. 3 is a diagram showing an example of a functional block implemented in the ECU 300. As shown in FIG. 3, the voltage VB, the current IB, and the temperature TB of the battery are input to the ECU 300 from the monitoring unit 200. The scheduled traveling start time Dt is input to the ECU 300 from the HMI device 600 and the user terminal 3. The ECU 300 receives the electric power amount fee unit price EuP and the outside air temperature information Te from the external server 5 through the network NW.

The SOC calculation unit 310 calculates the SOC of the battery 100 based on the voltage VB, the current IB, and the like. The planning unit 320 creates a temperature raising plan HP. The planning unit 320 includes a charge electric power amount calculation unit 321, a charge electricity fee calculation unit 322, a charge electric power amount fee unit price calculation unit 323, a scheduled traveling start time acquisition unit 324, and a target temperature acquisition unit 325.

As described in S12 (FIG. 2), the charge electric power amount calculation unit 321 calculates the charge electric power amount CA from, for example, the SOC at the start of charging and the SOC at the end of charging. As described in S12, the charge electricity fee calculation unit 322 calculates, using the electric power amount fee unit price EuP of the external power supply in each time slot from the start of charging to the end of charging, the electric power amount supplied to the battery 100 during charging, and the like, the charge electricity fee Cc that is the electricity fee required for the current charging. The charge electric power amount fee unit price calculation unit 323 calculates the charge electric power amount fee unit price CuP by dividing the charge electricity fee Cc by the charge electric power amount CA.

The scheduled traveling start time acquisition unit 324 acquires the scheduled traveling start time Dt input to the ECU 300 from the HMI device 600 or the user terminal 3. Alternatively, the scheduled traveling start time acquisition unit 324 may estimate the scheduled traveling start time Dt from past performance based on the season, the day of the week, and the like using a machine-learned learning model. The target temperature acquisition unit 325 reads out the target temperature Ttb stored in the memory 302. The target temperature acquisition unit 325 may correct the read target temperature Ttb based on the SOH of the battery 100.

As described in S14, the planning unit 320 creates the temperature raising plan HP based on the scheduled traveling start time Dt, the current temperature TB of the battery 100, the outside air temperature information Te, the target temperature Ttb, the electric power amount fee unit price EuP, and the charge electric power amount fee unit price CuP. The temperature raising plan HP is an energization schedule including the electric power to be supplied to the electric heater 810, the energization time slot (energization start time and energization end time), and the power source to the electric heater 810.

The power controller 330 controls the energization (electric power supply) of the electric heater 810 based on the temperature raising plan HP created by the planning unit 320 and the SOC of the battery 100 as described in S16 to S21.

According to the present embodiment, the electrified vehicle 1 includes the battery 100 that is externally charged by the electric power to be supplied from the external AC power supply 2. The battery temperature raising unit 802 of the temperature adjustment device 800 raises the temperature of the battery 100 by energization of the electric heater 810. The planning unit 320 of the ECU 300 creates the temperature raising plan from the end of the external charging to the scheduled traveling start time Dt such that the temperature TB of the battery 100 is the target temperature Ttb at the scheduled traveling start time Dt. The power controller 330 of the ECU 300 controls the electric power to be supplied to the electric heater 810 based on the temperature raising plan. The planning unit 320 calculates the charge electric power amount fee unit price CuP that is the electricity fee unit price required for the current charging, and creates the temperature raising plan such that the electric power of the battery 100 is used in a time slot in which the electric power amount fee unit price EuP of the external AC power supply 2 is higher than the charge electric power amount fee unit price CuP, and the electric power of the external AC power supply 2 is used in a time slot in which the electric power amount fee unit price EuP is equal to or lower than the charge electric power amount fee unit price CuP. Therefore, the temperature of the battery 100 at the scheduled traveling start time Dt can be raised to the target temperature Ttb. In addition, in the time slot in which the electric power amount fee unit price EuP of the external AC power supply 2 is higher than the charge electric power amount fee unit price CuP, the electric power of the battery 100 is used, so that the electricity fee required for raising the temperature can be suppressed.

In a case where the SOC of the battery 100 is equal to or less than the predetermined value A, the power controller 330 supplies the electric power of the external AC power supply 2 to the electric heater 810. Accordingly, since the SOC of the battery 100 is not equal to or less than the predetermined value A at the start of traveling of the electrified vehicle 1, a decrease in the electric power amount that can be used during traveling can be suppressed while the electricity fee required for raising the temperature is suppressed.

According to the present embodiment, the temperature control method includes acquiring the scheduled traveling start time Dt of the electrified vehicle 1 (S13), acquiring the target temperature Ttb of the battery 100 at the scheduled traveling start time Dt (S13), acquiring the charge electricity fee Cc for the charge electric power amount CA from the start of charging to the end of charging from the external AC power supply 2 (S11), acquiring the electric power amount fee unit price EuP of the external AC power supply 2 (S12, 13), calculating the charge electric power amount fee unit price CuP based on the charge electricity fee Cc (S12), creating the temperature raising plan from the end of the charging from the external AC power supply 2 to the scheduled traveling start time Dt such that the temperature of the battery 100 is the target temperature Ttb at the scheduled traveling start time Dt (S14), and controlling the electric heater 810 based on the temperature raising plan (S16 to S21).

The temperature raising plan is created such that the electric power of the battery 100 is supplied to the electric heater 810 in a time slot in which the electric power amount fee unit price EuP of the external AC power supply 2 is higher than the charge electric power amount fee unit price CuP, and the electric power of the external AC power supply 2 is supplied to the electric heater 810 in a time slot in which the electric power amount fee unit price EuP is equal to or lower than the charge electric power amount fee unit price CuP. Therefore, the temperature of the battery 100 at the scheduled traveling start time Dt can be raised to the target temperature Ttb, and the electricity fee required for raising the temperature of the battery 100 can be suppressed.

In the temperature control method of the present embodiment, when the electric power to the electric heater 810 is controlled based on the temperature raising plan, and the SOC of the battery 100 is equal to or less than the predetermined value A, the electric power of the external AC power supply 2 is supplied to the electric heater 810 even in a time slot in which the electric power of the battery 100 is supplied to the electric heater 810 (S16 to S21). Accordingly, a decrease in the electric power amount that can be used during traveling of the electrified vehicle 1 can be suppressed while the electricity fee required for raising the temperature is suppressed.

In S14 of the above-described embodiment, the ECU 300 may determine the electric power to be supplied and the energization time slot in consideration of the electric power amount fee unit price EuP such that the electricity fee is inexpensive, and create the temperature raising plan. For example, in a case where the energization start time is included in the time slot in which the electric power amount fee unit price EuP is low and the energization end time is included in the time slot in which the electric power amount fee unit price EuP is high, the electricity fee may be low by setting the electric power to be supplied in the initial (low-priced time slot) of the energization time slot to be larger than the electric power to be supplied in the later (high-priced time slot) of the energization time slot, as compared to raising the temperature of the battery 100 using a uniform electric power to be supplied. In addition, in a case where the scheduled traveling start time Dt is included in the time slot in which the electric power amount fee unit price EuP is high, the electricity fee may be low even when the temperature TB at the switching time is raised to a temperature higher than the target temperature Ttb by energization in the low-priced time slot, the energization is stopped, and the temperature TB is lowered to the target temperature Ttb by heat dissipation at the scheduled traveling start time Dt, depending on a relationship between the time (switching time) at which the switching is made from the low-priced time slot to the high-priced time slot, the scheduled traveling start time Dt, and the expected outside air temperature at the start of traveling, as compared to a case where the energization is performed in the high-priced time slot.

As described above, the ECU 300 may determine the electric power to be supplied and the energization time based on the current temperature TB, the target temperature Ttb, the change in the outside air temperature from the current time to the scheduled traveling start time Dt, and the electric power amount fee unit price EuP, such that the electricity fee is low. In this case, the electricity fee during the temperature raising may be calculated in consideration of the power consumption of the electric pump that circulates the heat medium of the battery thermal circuit.

In the temperature raising plan, the electric power to be supplied and the energization time may be set such that the temperature TB of the battery 100 after the charging does not fall below the lowest temperature for suppressing freezing.

In the above-described embodiment, the electrified vehicle 1 is the BEV, but the electrified vehicle to which the present disclosure can be applied is not limited to the BEV. For example, the present disclosure can also be applied to a plug-in hybrid electric vehicle (PHEV) including an engine and a motor generator, and can also be applied to a fuel cell electric vehicle (FCEV) including a storage battery that can be externally charged. In addition, the electrified vehicle may be an industrial vehicle such as a forklift.

The embodiment disclosed this time should be considered to be exemplary examples and not to be restrictive in all respects. The scope of the present invention is shown by the scope of claims rather than the description of the embodiments described above, and is intended to include all changes within the meaning and scope equivalent to the scope of claims.

## Claims

1. An electrified vehicle that includes a storage battery configured to be charged by electric power to be supplied from an external power supply, the electrified vehicle comprising:
a temperature raising device configured to raise a temperature of the storage battery by using electric power; and
a control device configured to control the temperature raising device, wherein:
the control device includes
a planning unit configured to create a temperature raising plan from an end of charging to a scheduled traveling start time of the electrified vehicle such that the temperature of the storage battery is a predetermined temperature at the scheduled traveling start time, and
a power controller configured to control the electric power to be supplied to the temperature raising device based on the temperature raising plan; and
the planning unit is configured to
calculate a charge electric power amount fee unit price that is a unit price of an electricity fee required for current charging, and
create the temperature raising plan such that electric power of the storage battery is used in a time slot in which an electric power amount fee unit price of the external power supply is higher than the charge electric power amount fee unit price, and the electric power of the external power supply is used in a time slot in which the electric power amount fee unit price is equal to or lower than the charge electric power amount fee unit price.

2. The electrified vehicle according to claim 1, wherein the power controller is configured to supply the electric power of the external power supply to the temperature raising device in a case where a state of charge of the storage battery is equal to or less than a predetermined value.

3. The electrified vehicle according to claim 1 or 2, wherein:
the control device is configured to communicate with an external server; and
the planning unit is configured to acquire information on the unit price of the electricity fee from the external server.

4. A temperature control method of a storage battery of which a temperature is raised by a temperature raising device, the storage battery being mounted on a vehicle and configured to be charged from an external power supply, in which the temperature raising device is configured to raise the temperature of the storage battery by using electric power, the temperature control method comprising:
acquiring a scheduled traveling start time of an electrified vehicle;
acquiring a target temperature of the storage battery at the scheduled traveling start time;
acquiring a charge electricity fee for charge electric power amount from a start of charging to an end of charging from the external power supply;
acquiring an electric power amount fee unit price of the external power supply;
calculating a charge electric power amount fee unit price based on the charge electricity fee;
creating a temperature raising plan from the end of the charging to the scheduled traveling start time such that the temperature of the storage battery is the target temperature at the scheduled traveling start time; and
controlling the temperature raising device based on the temperature raising plan,
wherein the temperature raising plan is created such that
electric power of the storage battery is supplied to the temperature raising device in a time slot in which the electric power amount fee unit price of the external power supply is higher than the charge electric power amount fee unit price, and
electric power of the external power supply is supplied to the temperature raising device in a time slot in which the electric power amount fee unit price is equal to or lower than the charge electric power amount fee unit price.

5. The temperature control method according to claim 4, further comprising:
acquiring a state of charge of the storage battery,
wherein when the temperature raising device is controlled based on the temperature raising plan, the electric power of the external power supply is supplied to the temperature raising device even in a time slot in which the electric power of the storage battery is supplied to the temperature raising device in a case where the state of charge is equal to or less than a predetermined value.
